# EUROPEAN PATENT APPLICATION

(11) **EP 2 432 002 A1**
(43) Date of publication of application: **21.03.2012**
(21) Application number: 10774828.7
(22) Date of filing: 27.04.2010
(51) Int. Cl.: H01L 21/02, C30B 29/36, H01L 21/20, H01L 21/336, H01L 29/12, H01L 29/78

(54) **SILICON CARBIDE SUBSTRATE AND SEMICONDUCTOR DEVICE**

(30) Priority: 11.05.2009 JP 2009114737; 24.09.2009 JP 2009219065; 01.10.2009 JP 2009229764; 29.10.2009 JP 2009248621
(71) Applicant: Sumitomo Electric Industries, Ltd., Osaka-shi, Osaka 541-0041 (JP)
(72) Inventor: HARADA, Shin, Osaka-shi Osaka 554-0024 (JP); SASAKI, Makoto, Itami-shi Hyogo 664-0016 (JP); NISHIGUCHI, Taro, Itami-shi Hyogo 664-0016 (JP); NAMIKAWA, Yasuo, Osaka-shi Osaka 554-0024 (JP); FUJIWARA, Shinsuke, Itami-shi Hyogo 664-0016 (JP)
(74) Representative: Grünecker, Kinkeldey, Stockmair & Schwanhäusser
(86) International application number: PCT/JP2010/057442
(87) International publication number: WO 2010/131570

(57) **Abstract**

A silicon carbide substrate (1), which allows for reduced resistivity in the thickness direction thereof while restraining stacking faults from being produced due to heat treatment, includes: a base layer (10) made of silicon carbide; and a SiC layer (20) made of single-crystal silicon carbide and disposed on one main surface (10A) of the base layer (10). The base layer (10) has an impurity concentration greater than 2 × 10¹⁹ cm⁻³. Further, the SiC layer (20) has an impurity concentration greater than 5 × 10¹⁸ cm⁻³ and smaller than 2 × 10¹⁹ cm⁻³.

## Description

### TECHNICAL FIELD

The present invention relates to a silicon carbide substrate and a semiconductor device, more particularly, a silicon carbide substrate allowing for reduced resistivity in the thickness direction thereof while restraining stacking faults from being produced due to heat treatment, as well as a semiconductor device including such a silicon carbide substrate.

### BACKGROUND ART

In recent years, in order to achieve high breakdown voltage, low loss, and utilization of semiconductor devices under a high temperature environment, silicon carbide (SiC) has begun to be adopted as a material for a semiconductor device. Silicon carbide is a wide band gap semiconductor having a band gap larger than that of silicon, which has been conventionally widely used as a material for semiconductor devices. Hence, by adopting silicon carbide as a material for a semiconductor device, the semiconductor device can have a high breakdown voltage, reduced on-resistance, and the like. Further, the semiconductor device thus adopting silicon carbide as its material has characteristics less deteriorated even under a high temperature environment than those of a semiconductor device adopting silicon as its material, advantageously.

In order to manufacture the high-performance semiconductor device adopting silicon carbide as its material, it is effective to employ a process of preparing a substrate made of silicon carbide (silicon carbide substrate), and forming an epitaxial growth layer made of SiC on the silicon carbide substrate. Further, on-resistance of the device can be reduced by reducing resistivity of the substrate in the thickness direction thereof as much as possible when manufacturing, for example, a vertical type power device (such as a vertical type MOSFET (Metal Oxide Semiconductor Field Effect Transistor) using the silicon carbide substrate. Further, in order to reduce the resistivity of the substrate in the thickness direction thereof, for example, there can be employed a method of introducing an impurity, which is an n type dopant such as nitrogen, into the substrate at a high concentration (for example, see R. C. GLASS et al., "SiC Seeded Crystal Growth", Phys. stat. sol. (b), 1997, 202, p149-162 (Non-Patent Literature 1)).

### CITATION LIST

### NON PATENT LITERATURE

NPL 1: R. C. GLASS et al., "SiC Seeded Crystal Growth", Phys. stat. sol.(b), 1997, 202, p149-162

### SUMMARY OF INVENTION

### TECHNICAL PROBLEM

However, if the resistivity of the substrate is reduced by simply introducing the impurity into the substrate at a high concentration, the following problem takes place. That is, when fabricating a semiconductor device using the silicon carbide substrate, the silicon carbide substrate is subjected to heat treatment such as thermal cleaning for cleaning a surface of the silicon carbide substrate. On this occasion, stacking faults are produced in the silicon carbide substrate containing the impurity at a high concentration. When an epitaxial growth layer made of SiC is formed on the silicon carbide substrate, the stacking faults are propagated to the SiC layer. Here, assuming that the SiC constituting the silicon carbide substrate is for example 4H-SiC, each of the stacking faults to be produced has a structure of 3C type, which has a band gap smaller than that in the 4H type. Accordingly, the band gap becomes smaller locally in the region in which the stacking faults are produced. As a result, if a semiconductor device is fabricated using such a silicon carbide substrate, problems will take place such as reduced breakdown voltage and increased leakage current.

In view of this, the present invention has its object to provide a silicon carbide substrate allowing for reduced resistivity in the thickness direction thereof while restraining stacking faults from being produced due to heat treatment, as well as a semiconductor device including such a silicon carbide substrate.

### SOLUTION TO PROBLEM

A silicon carbide substrate according to the present invention includes: a base layer made of silicon carbide; and a SiC layer made of single-crystal silicon carbide and disposed on the base layer. The base layer has an impurity concentration greater than 2 × 10¹⁹ cm⁻³. The SiC layer has an impurity concentration greater than 5 × 10¹⁸ cm⁻³ and smaller than 2 × 10¹⁹ cm⁻³.

The present inventors have fully studied approaches for reducing resistivity of a silicon carbide substrate in the thickness direction thereof while restraining stacking faults from being produced due to heat treatment. As a result, it has been found that when the impurity concentration thereof is less than 2 × 10¹⁹ cm⁻³, stacking faults can be prevented from being produced due to heat treatment, but are unlikely to be prevented when the impurity concentration exceeds 2 × 10¹⁹ cm⁻³. Thus, stacking faults can be prevented from being produced at least in the SiC layer even when heat treatment is performed in a subsequent device process, by providing the silicon carbide substrate with the layer (base layer) having an impurity concentration greater than 2 × 10¹⁹ cm⁻³ and a small resistivity and the layer (SiC layer) disposed on the base layer and having an impurity concentration smaller than 2 × 10¹⁹ cm⁻³. Further, by forming an epitaxial growth layer made of silicon carbide on such a SiC layer so as to fabricate the semiconductor device, the resistivity of the silicon carbide substrate can be reduced by the existence of the base layer, while preventing influence of stacking faults, which can be produced in the base layer, over the characteristics of the semiconductor device. Meanwhile, when the SiC layer has an impurity concentration of 5 × 10¹⁸ cm⁻³ or smaller, the resistivity of the SiC layer becomes too large, disadvantageously.

In this way, according to the silicon carbide substrate of the present invention, there can be provided a silicon carbide substrate allowing for reduced resistivity in the thickness direction thereof while restraining stacking faults from being produced due to heat treatment. Here, the term "impurity" refers to an impurity to be introduced to produce a majority carrier in the silicon carbide substrate.

The silicon carbide substrate may further include an epitaxial growth layer formed on the SiC layer and made of single-crystal silicon carbide, wherein the epitaxial growth layer has a stacking fault density smaller than that in the base layer.

In forming an epitaxial growth layer on the SiC layer, for example, it is necessary to thermally clean the silicon carbide substrate or heat the substrate during the epitaxial growth. Even if the heating causes production of stacking faults in the base layer, the stacking faults can be restrained from being produced at least in the SiC layer as described above. Hence, also in the epitaxial growth layer formed on the SiC layer, stacking faults can be restrained from being produced. As a result, this silicon carbide substrate has the epitaxial growth layer with stacking faults being restrained from being produced therein while allowing for reduced resistivity. Hence, the silicon carbide substrate can be used to fabricate a semiconductor device that suppresses reduced breakdown voltage and increased leakage current. It should be noted that this epitaxial growth layer can be used as, for example, a buffer layer or a breakdown voltage holding layer (drift layer) in the semiconductor device.

In the silicon carbide substrate, the impurity contained in the base layer may be different from that contained in the SiC layer. In this way, a silicon carbide substrate can be provided which contains impurities appropriately depending on intended purpose of use.

In the silicon carbide substrate, the impurity contained in the base layer can be nitrogen or phosphorus, and the impurity contained in the SiC layer can be nitrogen or phosphorus. Each of nitrogen and phosphorus is suitable as an impurity for supplying the SiC with electrons, which serve as majority carriers.

In the silicon carbide substrate, a plurality of the SiC layers may be arranged side by side when viewed in a planar view. Explaining from a different point of view, the plurality of SiC layers may be arranged on and along the main surface of the base layer.

SiC does not have a liquid phase at an atmospheric pressure. In addition, crystal growth temperature thereof is 2000°C or greater, which is very high. This makes it difficult to control and stabilize growth conditions. Hence, it is difficult for a substrate made of single-crystal SiC to keep its high quality and have a large diameter. To address this, the plurality of SiC layers each obtained from a high-quality silicon carbide single-crystal are arranged side by side on the base layer having a large diameter when viewed in a planar view, thereby obtaining a silicon carbide substrate that can be handled as a substrate having a high-quality SiC layer and a large diameter. By using such a silicon carbide substrate, the process of manufacturing a semiconductor device can be improved in efficiency. It should be noted that in order to improve the efficiency of the process of manufacturing a semiconductor device, it is preferable that adjacent ones of the plurality of SiC layers are arranged in contact with one another. More specifically, for example, the plurality of SiC layers are preferably arranged in contact with one another in the form of a matrix. Further, each of adjacent SiC layers preferably has an end surface substantially perpendicular to the main surface thereof. In this way, the silicon carbide substrate can be readily formed. Here, for example, when the end surface and the main surface form an angle of not less than 85° and not more than 95°, it can be determined that the end surface and the main surface are substantially perpendicular to each other.

In the silicon carbide substrate, the base layer may be made of single-crystal silicon carbide, and a half width of X-ray rocking curve of the SiC layer may be smaller than that of the base layer.

As described above, it is difficult for a high-quality single-crystal silicon carbide to have a large diameter. Meanwhile, for efficient manufacturing in a process of manufacturing a semiconductor device using a silicon carbide substrate, a substrate provided with predetermined uniform shape and size is required. Hence, even when a high-quality silicon carbide single-crystal (for example, single-crystal silicon carbide having a high crystallinity) is obtained, a region that cannot be processed into such a predetermined shape and the like by cutting, etc., may not be effectively used.

To address this, in the silicon carbide substrate of the present invention, on the base layer processed into the predetermined shape and size, there can be disposed the SiC layer having a smaller half width of the X-ray rocking curve, i.e., having higher crystallinity than that of the base layer but not formed into the desired shape and the like. Such a silicon carbide substrate has the predetermined uniform shape and size, thus attaining effective manufacturing of semiconductor devices. Further, such a silicon carbide substrate utilizes the high-quality SiC layer to manufacture a semiconductor device, thereby effectively utilizing the high-quality single-crystal silicon carbide. As a result, the manufacturing cost of the semiconductor device using the silicon carbide substrate can be reduced.

In the silicon carbide substrate, the base layer may be made of single-crystal silicon carbide, and the SiC layer may have a micro pipe density lower than that of the base layer.

Further, in the silicon carbide substrate, the base layer may be made of single-crystal silicon carbide, and the SiC layer may have a dislocation density lower than that of the base layer.

Further, in the silicon carbide substrate, the base layer is made of single-crystal silicon carbide, and the SiC layer may have a threading screw dislocation density smaller than that of the base layer.

Further, in the silicon carbide substrate, the base layer is made of single-crystal silicon carbide, and the SiC layer may have a threading edge dislocation density smaller than that of the base layer.

Further, in the silicon carbide substrate, the base layer is made of single-crystal silicon carbide, and the SiC layer may have a basal plane dislocation density smaller than that of the base layer.

Further, in the silicon carbide substrate, the base layer is made of single-crystal silicon carbide, and the SiC layer may have a mixed dislocation density smaller than that of the base layer.

Further, in the silicon carbide substrate, the base layer is made of single-crystal silicon carbide, and the SiC layer may have a stacking fault density smaller than that of the base layer.

Further, in the silicon carbide substrate, the base layer is made of single-crystal silicon carbide, and the SiC layer may have a point defect density smaller than that of the base layer.

Accordingly, on the relatively low-quality but low-cost base layer processed into the predetermined shape and size suitable for manufacturing of a semiconductor device, there can be disposed the high-quality SiC layer not having the predetermined shape and size and having smaller micro pipe density and dislocation densities than those of the base layer (such as the threading screw dislocation density, the threading edge dislocation density, the basal plane dislocation density, the mixed dislocation density, the stacking fault density, and the point defect density). Such a silicon carbide substrate has the predetermined uniform shape and size suitable for manufacturing of a semiconductor device as a whole, thus attaining effective manufacturing of semiconductor devices. Further, such a silicon carbide substrate utilizes the high-quality SiC layer to manufacture a semiconductor device, thereby effectively utilizing the high-quality single-crystal silicon carbide. As a result, the manufacturing cost of the semiconductor device using the silicon carbide substrate can be reduced.

In the silicon carbide substrate, the base layer may include a single-crystal layer made of single-crystal silicon carbide and including its main surface facing the SiC layer. With this, in an early stage of a process of manufacturing a semiconductor device using the silicon carbide substrate, the silicon carbide substrate is maintained to have its large thickness and is therefore readily handled, and in the middle of the process of manufacturing, a region of the base layer other than the single-crystal layer is removed, whereby only the single-crystal layer of the base layer can remain within the semiconductor device. In this way, a high-quality semiconductor device can be manufactured while facilitating handling of the silicon carbide substrate in the process of manufacturing.

In the silicon carbide substrate, a half width of X-ray rocking curve of the SiC layer may be smaller than that of the single-crystal layer. As such, the SiC layer having such a smaller half width of the X-ray rocking curve, i.e., higher crystallinity than that of the single-crystal layer of the base layer is provided, thereby obtaining a silicon carbide substrate by which a high-quality semiconductor device can be obtained.

In the silicon carbide substrate, the SiC layer may have a micro pipe density lower than that of the single-crystal layer.

Further, in the silicon carbide substrate, the SiC layer may have a dislocation density lower than that of the single-crystal layer.

Further, in the silicon carbide substrate, the SiC layer may have a threading screw dislocation density smaller than that of the single-crystal layer.

Further, in the silicon carbide substrate, the SiC layer may have a threading edge dislocation density smaller than that of the single-crystal layer.

Further, in the silicon carbide substrate, the SiC layer may have a basal plane dislocation density smaller than that of the single-crystal layer.

Further, in the silicon carbide substrate, the SiC layer may have a mixed dislocation density smaller than that of the single-crystal layer.

Further, in the silicon carbide substrate, the SiC layer may have a stacking fault density smaller than that of the single-crystal layer.

Further, in the silicon carbide substrate, the SiC layer may have a point defect density smaller than that of the single-crystal layer.

Thus, as compared with the single-crystal layer of the base layer, the SiC layer has the reduced defect densities such as the micro pipe density, the threading screw dislocation density, the threading edge dislocation density, the basal plane dislocation density, the mixed dislocation density, stacking fault density, and the point defect density. With the SiC layer, the silicon carbide substrate allowing for manufacturing a high-quality semiconductor device can be obtained.

In the silicon carbide substrate, the SiC layer may have a main surface opposite to the base layer and having an off angle of not less than 50° and not more than 65° relative to a {0001} plane.

By growing single-crystal silicon carbide of hexagonal system in the <0001> direction, a high-quality single-crystal can be fabricated efficiently. From such a silicon carbide single-crystal grown in the <0001> direction, a silicon carbide substrate having a main surface corresponding to the {0001} plane can be obtained efficiently. Meanwhile, by using a silicon carbide substrate having a main surface having an off angle of not less than 50° and not more than 65° relative to the plane orientation of {0001}, a semiconductor device with high performance may be manufactured.

Specifically, for example, a silicon carbide substrate used for fabrication of a MOSFET generally has a main surface having an off angle of approximately 8° relative to a plane orientation of {0001}. An epitaxial growth layer is formed on this main surface and an oxide film, an electrode, and the like are formed on this epitaxial growth layer, thereby obtaining a MOSFET. In this MOSFET, a channel region is formed in a region including an interface between the epitaxial growth layer and the oxide film. However, in the MOSFET having such a structure, a multiplicity of interface states are formed around the interface between the epitaxial growth layer and the oxide film, i.e., the location in which the channel region is formed, due to the substrate's main surface having an off angle of approximately 8° or smaller relative to the plane orientation of {0001}. This hinders traveling of carriers, thus decreasing channel mobility.

To address this, in the silicon carbide substrate, the main surface of the SiC layer opposite to the base layer is adapted to have an off angle of not less than 50° and not more than 65° relative to the {0001} plane, thereby reducing formation of the interface states. In this way, a MOSFET can be fabricated which allows for reduced on-resistance.

In the silicon carbide substrate, the main surface of the SiC layer opposite to the base layer may have an off orientation forming an angle of 5° or smaller relative to a <1-100> direction.

The <1-100> direction is a representative off orientation in a silicon carbide substrate. Variation in the off orientation resulting from variation in a slicing process of the process of manufacturing the substrate is adapted to be 5° or smaller, which allows an epitaxial growth layer to be formed readily on the silicon carbide substrate.

In the silicon carbide substrate, the main surface of the SiC layer opposite to the base layer may have an off angle of not less than -3° and not more than 5° relative to a {03-38} plane in the <1-100> direction. Accordingly, channel mobility can be further improved in the case where a MOSFET is fabricated using the silicon carbide substrate. Here, setting the off angle at not less than -3° and not more than +5° relative to the plane orientation of {03-38} is based on a fact that particularly high channel mobility was obtained in this set range as a result of inspecting a relation between the channel mobility and the off angle.

Further, the "off angle relative to the {03-38} plane in the <1-100> direction" refers to an angle formed by an orthogonal projection of a normal line of the above-described main surface to a flat plane defined by the <1-100> direction and the <0001> direction, and a normal line of the {03-38} plane. The sign of positive value corresponds to a case where the orthogonal projection approaches in parallel with the <1-100> direction whereas the sign of negative value corresponds to a case where the orthogonal projection approaches in parallel with the <0001> direction.

It should be noted that the main surface preferably has a plane orientation of substantially {03-38}, and the main surface more preferably has a plane orientation of {03-38}. Here, the expression "the main surface has a plane orientation of substantially {03-38}" is intended to encompass a case where the plane orientation of the main surface of the substrate is included in a range of off angle such that the plane orientation can be substantially regarded as {03-38} in consideration of processing accuracy of the substrate. In this case, the range of off angle is, for example, a range of off angle of ±2° relative to {03-38}. Accordingly, the above-described channel mobility can be further improved.

In the silicon carbide substrate, the main surface opposite to the base layer may have an off orientation forming an angle of 5° or smaller relative to a <11-20> direction.

<11-20> is a representative off orientation in a silicon carbide substrate, as with the <1-100> direction. Variation in the off orientation resulting from variation in the slicing process of the process of manufacturing the substrate is adapted to be ±5°, which allows an epitaxial growth layer to be formed readily on the SiC layer.

A semiconductor device according to the present invention includes: a silicon carbide substrate; an epitaxial growth layer formed on the silicon carbide substrate; and an electrode formed on the epitaxial growth layer. The silicon carbide substrate is the above-described silicon carbide substrate of the present invention.

Because the semiconductor device of the present invention includes the above-described silicon carbide substrate of the present invention, there can be provided a semiconductor device allowing for reduced resistivity in the thickness direction of the substrate while restraining stacking faults from being produced.

### ADVANTAGEOUS EFFECTS OF INVENTION

As apparent from the description above, according to the silicon carbide substrate of the present invention, there can be provided a silicon carbide substrate allowing for reduced resistivity in the thickness direction thereof while restraining stacking faults from being produced due to heat treatment. Further, according to the semiconductor device of the present invention, there can be provided a semiconductor device allowing for reduced resistivity in the thickness direction of the substrate while restraining stacking faults from being produced.

### BRIEF DESCRIPTION OF DRAWINGS

Fig. 1 is a schematic cross sectional view showing a structure of a silicon carbide substrate.
Fig. 2 is a schematic cross sectional view showing the structure of the silicon carbide substrate having an epitaxial layer formed thereon.
Fig. 3 is a flowchart schematically showing a method for manufacturing the silicon carbide substrate.
Fig. 4 is a flowchart schematically showing another method for manufacturing the silicon carbide substrate.
Fig. 5 is a schematic cross sectional view for illustrating the method for manufacturing the silicon carbide substrate.
Fig. 6 is a schematic cross sectional view for illustrating the method for manufacturing the silicon carbide substrate.
Fig. 7 is a schematic cross sectional view for illustrating the method for manufacturing the silicon carbide substrate.
Fig. 8 is a schematic cross sectional view showing another structure of the silicon carbide substrate.
Fig. 9 is a schematic cross sectional view showing still another structure of the silicon carbide substrate.
Fig. 10 is a flowchart schematically showing a method for manufacturing the silicon carbide substrate of Fig. 9.
Fig. 11 is a schematic cross sectional view showing yet another structure of the silicon carbide substrate.
Fig. 12 is a flowchart schematically showing a method for manufacturing the silicon carbide substrate of Fig. 11.
Fig. 13 is a schematic cross sectional view showing a structure of a vertical type MOSFET.
Fig. 14 is a flowchart schematically showing a method for manufacturing the vertical type MOSFET.
Fig. 15 is a schematic cross sectional view for illustrating the method for manufacturing the vertical type MOSFET.
Fig. 16 is a schematic cross sectional view for illustrating the method for manufacturing the vertical type MOSFET.
Fig. 17 is a schematic cross sectional view for illustrating the method for manufacturing the vertical type MOSFET.
Fig. 18 is a schematic cross sectional view for illustrating the method for manufacturing the vertical type MOSFET.

### DESCRIPTION OF EMBODIMENTS

The following describes embodiments of the present invention with reference to figures. It should be noted that in the below-mentioned figures, the same or corresponding portions are given the same reference characters and are not described repeatedly.

### (First Embodiment)

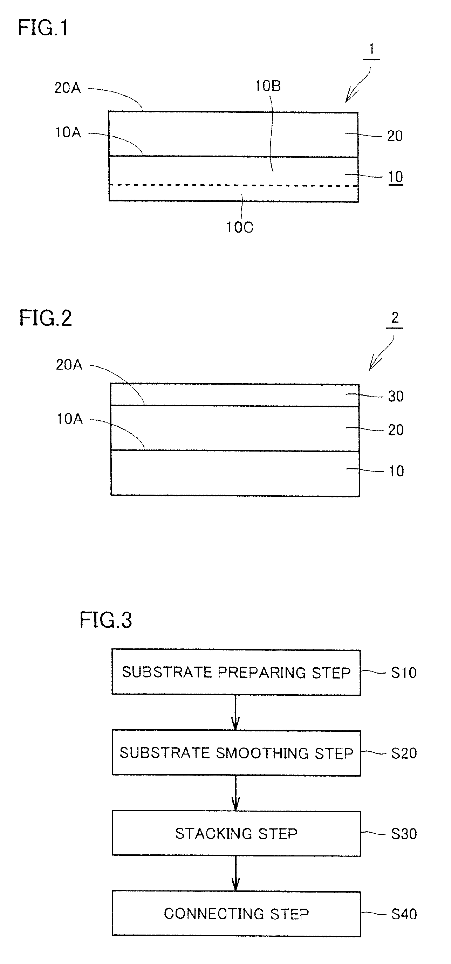

First, one embodiment of the present invention, i.e., a first embodiment will be described. Referring to Fig. 1, a silicon carbide substrate 1 of the present embodiment includes: a base layer 10 made of silicon carbide; and a SiC layer 20 made of single-crystal silicon carbide and disposed on one main surface 10A of base layer 10. Base layer 10 has an impurity concentration greater than 2 × 10¹⁹ cm⁻³. SiC layer 20 has an impurity concentration greater than 5 × 10¹⁸ cm⁻³ and smaller than 2 × 10¹⁹ cm⁻³.

Even when silicon carbide substrate 1 is provided with base layer 10 thus having an impurity concentration greater than 2 × 10¹⁹ cm⁻³ and having a small resistivity, SiC layer 20 having an impurity concentration smaller than 2 × 10¹⁹ cm⁻³ and provided on base layer 10 restrains stacking faults from being produced at least in SiC layer 20 if heat treatment is performed in a subsequent device process.

Then, when an epitaxial growth layer 30 made of single-crystal silicon carbide is formed on main surface 20A of SiC layer 20 opposite to base layer 10 as shown in Fig. 2, stacking faults that can be generated in base layer 10 are not propagated to epitaxial growth layer 30. Accordingly, stacking fault density in epitaxial growth layer 30 is smaller than that in base layer 10.

Thus, silicon carbide substrate 1 allows for reduced resistivity in the thickness direction thereof while restraining stacking faults from being produced due to heat treatment in a device manufacturing process.

Here, in silicon carbide substrate 1, the impurity contained in base layer 10 may be different from that contained in SiC layer 20. In this way, there can be obtained a silicon carbide substrate containing impurities appropriately depending on intended purpose of use. Further, the impurity contained in base layer 10 may be nitrogen or phosphorus, whereas the impurity contained in SiC layer 20 may be also nitrogen or phosphorus.

Further, in silicon carbide substrate 1, base layer 10 is made of single-crystal silicon carbide, and the half width of X-ray rocking curve of SiC layer 20 may be smaller than that of base layer 10.

Accordingly, a single-crystal silicon carbide having predetermined uniform shape and size and having relatively low crystallinity is employed as base layer 10 of silicon carbide substrate 1, while a single-crystal silicon carbide having a high crystallinity and not having the desired shape or the like is effectively utilized as SiC layer 20. As a result, by fabricating a semiconductor device using such a silicon carbide substrate 1, manufacturing cost of the semiconductor device can be reduced.

Further, in silicon carbide substrate 1, base layer 10 may be made of single-crystal silicon carbide, and SiC layer 20 may have a micro pipe density lower than that of base layer 10. Further, in silicon carbide substrate 1, base layer 10 may be made of single-crystal silicon carbide, and SiC layer 20 may have a dislocation density lower than that of base layer 10. Further, in silicon carbide substrate 1, base layer 10 may be made of single-crystal silicon carbide, and SiC layer 20 may have a threading screw dislocation density smaller than that of base layer 10. Further, in silicon carbide substrate 1, base layer 10 may be made of single-crystal silicon carbide, and SiC layer 20 may have a threading edge dislocation density smaller than that of base layer 10. Further, in silicon carbide substrate 1, base layer 10 may be made of single-crystal silicon carbide, and SiC layer 20 may have a basal plane dislocation density smaller than that of base layer 10. Further, in silicon carbide substrate 1, base layer 10 may be made of single-crystal silicon carbide, and SiC layer 20 may have a mixed dislocation density smaller than that of base layer 10. Further, in silicon carbide substrate 1, base layer 10 may be made of single-crystal silicon carbide, and SiC layer 20 may have a stacking fault density smaller than that of base layer 10. Further, in silicon carbide substrate 1, base layer 10 may be made of single-crystal silicon carbide, and SiC layer 20 may have a point defect density smaller than that of base layer 10.

Accordingly, a single-crystal silicon carbide having predetermined uniform shape and size and having a relatively low quality is employed as base layer 10 of silicon carbide substrate 1, while a single-crystal silicon carbide having a high quality and not having the desired shape or the like is effectively utilized as SiC layer 20. Thus, by fabricating a semiconductor device using such a silicon carbide substrate 1. manufacturing cost of the semiconductor device can be reduced.

Further, in silicon carbide substrate 1, base layer 10 may include a single-crystal layer 10B made of single-crystal silicon carbide and including main surface 10A located at a side facing SiC layer 20. With this, in an early stage of a process of manufacturing a semiconductor device using silicon carbide substrate 1, silicon carbide substrate 1 is maintained to have its large thickness and is therefore readily handled, and in the middle of the process of manufacturing, a region 10C of base layer 10 other than the single-crystal layer is removed, whereby only single-crystal layer 10B of base layer 10 can remain within the semiconductor device. In this way, a high-quality semiconductor device can be manufactured while facilitating handling of silicon carbide substrate 1 in the process of manufacturing.

Further, in silicon carbide substrate 1, the half width of X-ray rocking curve of SiC layer 20 may be smaller than that of single-crystal layer 10B. As such, SiC layer 20 having such a smaller half width of the X-ray rocking curve, i.e., having higher crystallinity than that of single-crystal layer 10B of base layer 10 is provided, thereby obtaining silicon carbide substrate 1 by which a high-quality semiconductor device can be manufactured. Further, in silicon carbide substrate 1, SiC layer 20 may have a micro pipe density lower than that of single-crystal layer 10B. Further, in silicon carbide substrate 1, SiC layer 20 may have a dislocation density lower than that of single-crystal layer 10B. Further, in silicon carbide substrate 1, SiC layer 20 may have a threading screw dislocation density smaller than that of single-crystal layer 10B. Further, in silicon carbide substrate 1, SiC layer 20 may have a threading edge dislocation density smaller than that of single-crystal layer 10B. Further, in silicon carbide substrate 1, SiC layer 20 may have a basal plane dislocation density smaller than that of single-crystal layer 10B. Further, in silicon carbide substrate 1, SiC layer 20 may have a mixed dislocation density smaller than that of single-crystal layer 10B. Further, in silicon carbide substrate 1, SiC layer 20 may have a stacking fault density smaller than that of single-crystal layer 10B. Further, in silicon carbide substrate 1, SiC layer 20 may have a point defect density smaller than that of single-crystal layer 10B.

Thus, as compared with single-crystal layer 10B of base layer 10, SiC layer 20 has the reduced defect densities such as the micro pipe density, the threading screw dislocation density, the threading edge dislocation density, the basal plane dislocation density, the mixed dislocation density, stacking fault density, and the point defect density. With such a SiC layer 20, silicon carbide substrate 1 allowing for manufacturing of a high-quality semiconductor device can be obtained.

Here, in silicon carbide substrate 1 described above, main surface 20A of each of SiC substrates 20 may have an off angle of not less than 50° and not more than 65° relative to the {0001} plane. By fabricating a MOSFET using such a silicon carbide substrate 1, formation of interface states can be reduced in a channel region, thereby obtaining a MOSFET reduced in on-resistance. Meanwhile, in order to facilitate the manufacturing, main surface 20A of SiC layer 20 may correspond to the {0001} plane.

Further, the off orientation of main surface 20A of SiC layer 20 may form an angle of 5° or less relative to the <1-100> direction. The <1-100> direction is a representative off orientation in a silicon carbide substrate. Variation in the off orientation resulting from variation in a slicing process of the process of manufacturing the substrate is adapted to be 5° or smaller, which allows an epitaxial growth layer to be formed readily on silicon carbide substrate 1.

Further, in silicon carbide substrate 1, main surface 20A of SiC layer 20 preferably has an off angle of not less than -3° and not more than 5° relative to the {03-38} plane in the <1-100> direction. Accordingly, channel mobility can be further improved in the case where a MOSFET is fabricated using silicon carbide substrate 1.

In silicon carbide substrate 1, the off orientation of main surface 20A of SiC layer 20 may form an angle of 5° or smaller relative to the <11-20> direction.

<11-20> is also a representative off orientation in a silicon carbide substrate. Variation in the off orientation resulting from variation in a slicing process of the process of manufacturing the substrate is adapted to be ±5°, which allows an epitaxial growth layer to be formed readily on silicon carbide substrate 1.

Further, in silicon carbide substrate 1, SiC layer 20 may be made of single-crystal silicon carbide different from that of base layer 10. Here, the expression "SiC layer 20 is made of single-crystal silicon carbide different from that of base layer 10" encompasses a case where base layer 10 is made of silicon carbide, which is not of single-crystal such as polycrystal silicon carbide or amorphous silicon carbide; and a case where base layer 10 is made of single-crystal silicon carbide different in crystal from that of SiC layer 20. The expression "base layer 10 and SiC layer 20 are made of silicon carbide different in crystal" refers to, for example, a state in which a defect density in one side relative to a boundary between base layer 10 and SiC layer 20 is different from that in the other side. In this case, the defect densities may be discontinuous at the boundary.

The following describes an exemplary method for manufacturing silicon carbide substrate 1 described above. Referring to Fig. 3, in the method for manufacturing the silicon carbide substrate in the present embodiment, first, as a step (S10), a substrate preparing step is performed. In this step (S10), base substrate 10 made of single-crystal silicon carbide and SiC substrate 20 are prepared. SiC substrate 20 has the main surface, which will be main surface 20A of SiC layer 20 that will be obtained by this manufacturing method (see Fig. 1). Hence, on this occasion, the plane orientation of the main surface of SiC substrate 20 is selected in accordance with desired plane orientation of main surface 20A. Here, for example, a SiC substrate 20 having a main surface corresponding to the {03-38} plane is prepared. Meanwhile, a substrate having an impurity concentration greater than 2 × 10¹⁹ cm⁻³ is adopted as base substrate 10. Further, as SiC substrate 20, there is adopted a substrate having an impurity concentration greater than 5 × 10¹⁸ cm⁻³ and smaller than 2 × 10¹⁹ cm⁻³.

Next, a substrate smoothing step is performed as a step (S20). In this step (S20), the main surfaces of base substrate 10 and SiC substrate 20 (connection surface) are smoothed by, for example, polishing. The main surfaces are to be brought into contact with each other in a below-described step (S30). It should be noted that this step (S20) is not an essential step, but provides, if performed, a small gap between base substrate 10 and SiC substrate 20, which are to face each other, and accordingly provides a uniform interval therebetween. Hence, in a below-described step (S40), uniformity is improved in reaction (connection) at the connection surface. This allows base substrate 10 and SiC substrate 20 to be connected to each other more securely. In order to connect base substrate 10 and SiC substrate 20 to each other further securely, the above-described connection surface preferably has a surface roughness Ra of less than 100 nm, more preferably, less than 50 nm. Further, by setting surface roughness Ra of the connection surface at less than 10 nm, more secure connection can be achieved.

Meanwhile, step (S20) may be omitted, i.e., step (S30) may be performed without polishing the main surfaces of base substrate 10 and SiC substrate 20, which are to be brought into contact with each other. This reduces manufacturing cost of silicon carbide substrate 1. Further, for removal of damaged layers located in surfaces formed by slicing upon fabrication of base substrate 10 and SiC substrate 20, a step of removing the damaged layers may be performed by, for example, etching instead of step (S20) or after step (S20), and then step (S30) described below may be performed.

Next, a stacking step is performed as step (S30). In this step (S30), SiC substrate 20 is placed on and in contact with the main surface of base substrate 10, thereby fabricating a stacked substrate.

Next, as step (S40), a connecting step is performed. In step (S40), base substrate 10 and SiC substrate 20 are connected to each other by heating the stacked substrate. With the above-described process, silicon carbide substrate 1 of the first embodiment can be readily manufactured which includes the connected SiC substrate 20 as SiC layer 20. In this step (S40), the stacked substrate may be heated in an atmosphere obtained by reducing pressure of the atmospheric air. This reduces manufacturing cost of silicon carbide substrate 1.

Further, by epitaxially growing single-crystal silicon carbide on silicon carbide substrate 1 to form an epitaxial growth layer 30 on main surface 20A of SiC layer 20, a silicon carbide substrate 2 shown in Fig. 2 can be manufactured.

Here, in the stacked substrate fabricated in step (S30), the gap formed between base substrate 10 and SiC substrate 20 is preferably 100 µm or smaller. Each of base substrate 10 and SiC substrate 20 has slight warpage, curve, or the like, even in the case where they have high surface smoothness. Hence, a gap is formed between base substrate 10 and SiC substrate 20 in the stacked substrate. If this gap is more than 100 ×m, a state of connection between base substrate 10 and SiC substrate 20 may not become uniform. By setting the gap between base substrate 10 and SiC substrate 20 to be not more than 100 µm, base substrate 10 and SiC substrate 20 can be uniformly connected to each other more securely.

Further, in step (S40), it is preferable to heat the above-described stacked substrate to fall within a range of temperature equal to or higher than the sublimation temperature of silicon carbide. This allows base substrate 10 and SiC substrate 20 to be connected to each other more securely. In particular, by setting a gap to be not more than 100 µm between base substrate 10 and SiC substrate 20 in the stacked substrate, they can be uniformly connected to each other by the sublimation of SiC. In this case, base substrate 10 and SiC substrate 20 can be connected to each other readily even in the case where step (S20) is not performed and step (S30) is performed without polishing the main surfaces of base substrate 10 and SiC substrate 20 which are to be brought into contact with each other.

Further, heating temperature for the stacked substrate in step (S40) is preferably not less than 1800°C and not more than 2500°C. If the heating temperature is lower than 1800°C, it takes a long time to connect base substrate 10 and SiC substrate 20, which results in decreased efficiency in manufacturing silicon carbide substrate 1. On the other hand, if the heating temperature exceeds 2500°C, surfaces of base substrate 10 and SiC substrate 20 become rough, which may result in generation of a multiplicity of crystal defects in silicon carbide substrate 1 to be fabricated. In order to improve efficiency in manufacturing while restraining generation of defects in silicon carbide substrate 1, the heating temperature for the stacked substrate in step (S40) is set at not less than 1900°C and not more than 2100°C. Further, in this step (S40), the stacked substrate may be heated under a pressure higher than 10⁻¹ Pa and lower than 10⁴ Pa. This can accomplish the above-described connection using a simple device, and provide an atmosphere for accomplishing the connection for a relatively short time, thereby achieving reduced manufacturing cost of silicon carbide substrate 1. Further, the atmosphere upon the heating in step (S40) may be inert gas atmosphere. In the case where the atmosphere is the inert gas atmosphere, the inert gas atmosphere preferably contains at least one selected from a group consisting of argon, helium, and nitrogen.

### (Second Embodiment)

The following describes another embodiment of the present invention, i.e., a second embodiment. Referring to Fig. 1, a silicon carbide substrate 1 in the second embodiment has basically the same structure and provides basically the same effects as those of silicon carbide substrate 1 in the first embodiment. However, silicon carbide substrate 1 in the second embodiment is different from that of the first embodiment in terms of its manufacturing method.

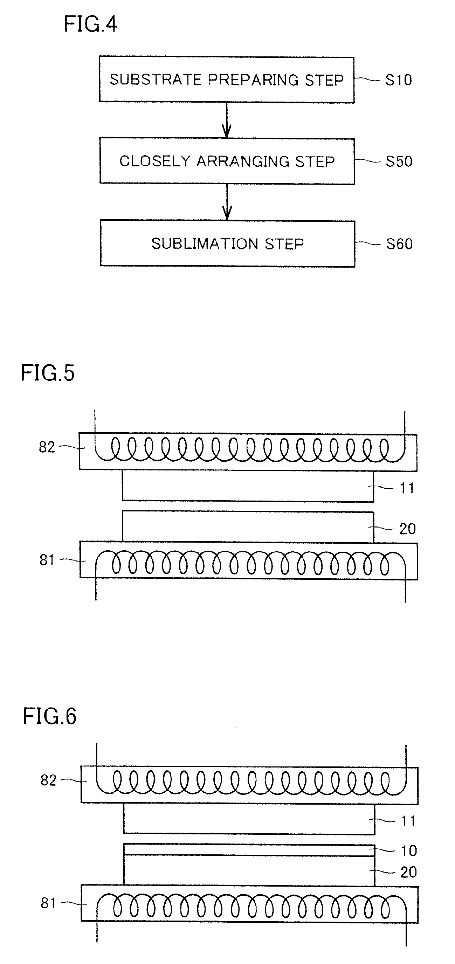

Referring to Fig. 4, the substrate preparing step is first performed as step (S10) in the method for manufacturing the silicon carbide substrate in the second embodiment. In step (S10), a SiC substrate is prepared as with the first embodiment, and a material substrate made of silicon carbide is prepared.

Next, referring to Fig. 4, a closely arranging step is performed as a step (S50). In step (S50), referring to Fig. 5, SiC substrate 20 and material substrate 11 are held by a first heater 81 and a second heater 82, which are disposed face to face with each other. Here, an appropriate value of a space between SiC substrate 20 and material substrate 11 is considered to be associated with a mean free path for a sublimation gas obtained upon heating in a below-described step (S60). Specifically, the average value of the space between SiC substrate 20 and material substrate 11 can be set to be smaller than the mean free path for the sublimation gas obtained upon heating in the below-described step (S60). For example, strictly, a mean free path for atoms and molecules depends on atomic radius and molecule radius at a pressure of 1 Pa and a temperature of 2000°C. but is approximately several cm to several ten cm. Hence, realistically, the space is preferably set at several cm or smaller. More specifically, SiC substrate 20 and material substrate 11 are disposed with a space of not less than 1 µm and not more than 1 cm therebetween such that their main surfaces face each other. Further, when the average value of the space is 1 cm or smaller, distribution in thickness of base layer 10 to be formed in a step (S60) described below can be reduced. Furthermore, when the average value of the space is 1 mm or smaller, the distribution in film thickness of base layer 10 can be reduced further. Meanwhile, with the average value of the space being 1 µm or greater, there can be secured a sufficient space for sublimation of silicon carbide. It should be noted that this sublimation gas is a gas formed by sublimation of solid silicon carbide, and includes Si, Si₂C, and SiC₂, for example.

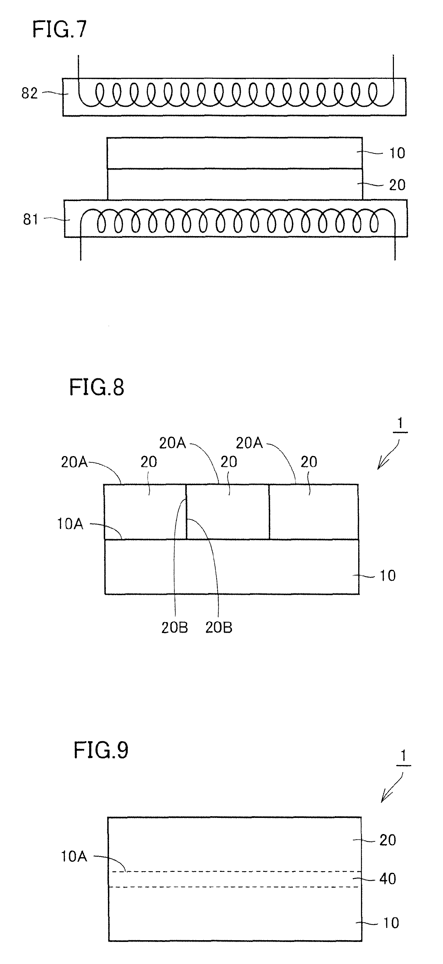

Next, as step (S60), a sublimation step is performed. In this step (S60), SiC substrate 20 is heated to a predetermined substrate temperature by first heater 81. Further, material substrate 11 is heated to a predetermined material temperature by second heater 82. On this occasion, material substrate 11 is heated to reach the material temperature, thereby sublimating SiC from the surface of the material substrate. On the other hand, the substrate temperature is set lower than the material temperature. Specifically, for example, the substrate temperature is set lower than the material temperature by not less than 1°C and not more than 100°C. The substrate temperature is preferably 1800°C or greater and 2500°C or smaller. Accordingly, as shown in Fig. 6, SiC sublimated from material substrate 11 in the form of gas reaches the surface of SiC substrate 20 and is accordingly solidified thereon, thereby forming base layer 10. With this state being maintained, as shown in Fig. 7, all the SiC constituting material substrate 11 is sublimated and is transferred onto the surface of SiC substrate 20. Accordingly, step (S60) is completed, thereby completing silicon carbide substrate 1 shown in Fig. 1.

### (Third Embodiment)

The following describes still another embodiment of the present invention, i.e., a third embodiment. Referring to Fig. 8, a silicon carbide substrate 1 in the third embodiment has basically the same configuration and provides basically the same effects as those of silicon carbide substrate 1 in the first embodiment. However, silicon carbide substrate 1 in the third embodiment is different from that of the first embodiment in that a plurality of SiC layers 20 are arranged side by side when viewed in a planar view.

Namely, referring to Fig. 8, in silicon carbide substrate 1 of the third embodiment, the plurality of SiC layers 20 are arranged side by side when viewed in a planar view. In other words, the plurality of SiC layers 20 are arranged along main surface 10A of base layer 10. More specifically, the plurality of SiC layers 20 are arranged in the form of a matrix on base substrate 10 such that adjacent SiC layers 20 are in contact with each other. Accordingly, silicon carbide substrate 1 of the present embodiment can be handled as a substrate having high-quality SiC layers 20 and a large diameter. Utilization of such a silicon carbide substrate 1 allows for efficient manufacturing process of semiconductor devices. Further, referring to Fig. 8, each of adjacent SiC layers 20 has an end surface 20B substantially perpendicular to main surface 20A of SiC layer 20. In this way, silicon carbide substrate 1 of the present embodiment can be readily manufactured. It should be noted that silicon carbide substrate 1 in the third embodiment can be manufactured in a manner similar to that in the first embodiment or the second embodiment as follows. That is, in step (S30) of the first embodiment, a plurality of SiC substrates 20 each having an end surface 20B substantially perpendicular to main surface 20A thereof are arranged side by side when viewed in a planar view. Alternatively, in step (S50) of the second embodiment, a plurality of SiC substrates 20 each having an end surface 20B substantially perpendicular to main surface 20A thereof are arranged side by side on and held by first heater 81.

### (Fourth Embodiment)

The following describes yet another embodiment of the present invention, i.e., a fourth embodiment. Referring to Fig. 9, a silicon carbide substrate 1 in the fourth embodiment has basically the same configuration and provides basically the same effects as those of silicon carbide substrate 1 in the first embodiment. However, silicon carbide substrate 1 in the fourth embodiment is different from that of the first embodiment in that an amorphous SiC layer serving as an intermediate layer is provided between base layer 10 and SiC layer 20.

Namely, in silicon carbide substrate 1 in the fourth embodiment, an amorphous SiC layer 40 is disposed between base layer 10 and SiC layer 20 as an intermediate layer made of amorphous SiC. Then, base layer 10 and SiC layer 20 are connected to each other by this amorphous SiC layer 40. Amorphous SiC layer 40 thus existing facilitates to provide silicon carbide substrate 1 in which base layer 10 and SiC layer 20 having different impurity concentrations are stacked on each other.

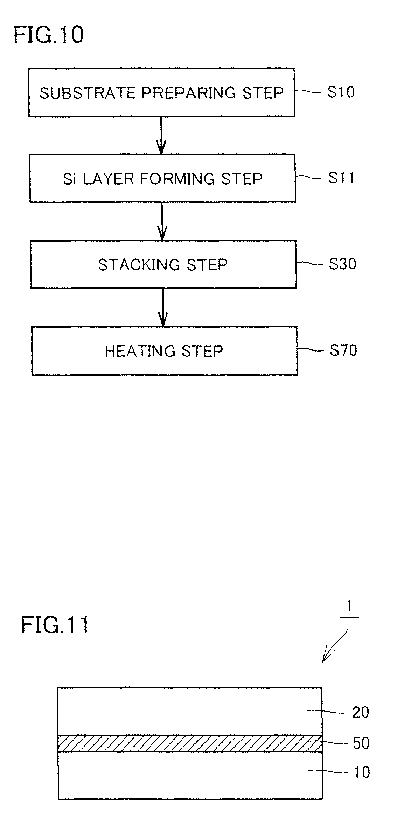

The following describes a method for manufacturing silicon carbide substrate 1 in the fourth embodiment. Referring to Fig. 10, in the method for manufacturing silicon carbide substrate 1 in the fourth embodiment, the substrate preparing step is performed as step (S10) in the same way as in the first embodiment, so as to prepare base substrate 10 and SiC substrate 20.

Next, a Si layer forming step is performed as a step (S11). In this step (S11), a Si layer having a thickness of approximately 100 nm is formed on one main surface of base substrate 10 prepared in step (S10), for example. This Si layer can be formed using the sputtering method, for example.

Next, a stacking step is performed as step (S30). In this step (S30), SiC substrate 20 prepared in step (S10) is placed on the Si layer formed in step (S11). In this way, a stacked substrate is obtained in which SiC substrate 20 is provided over base substrate 10 with the Si layer interposed therebetween.

Next, as a step (S70), a heating step is performed. In this step (S70), the stacked substrate fabricated in step (S30) is heated, for example, in a mixed gas atmosphere of hydrogen gas and propane gas under a pressure of 1 × 10³ Pa at approximately 1500°C for 3 hours. Accordingly, the Si layer is supplied with carbon as a result of diffusion mainly from base substrate 10 and SiC substrate 20, thereby forming amorphous SiC layer 40 as shown in Fig. 9. Accordingly, silicon carbide substrate 1 of the fourth embodiment can be readily manufactured in which base layer 10 and SiC layer 20 having different impurity concentrations are connected to each other by amorphous SiC layer 40.

### (Fifth Embodiment)

The following describes yet another embodiment of the present invention, i.e., a fifth embodiment. Referring to Fig. 11, a silicon carbide substrate 1 in the fifth embodiment has basically the same configuration and provides basically the same effects as those of silicon carbide substrate 1 in the first embodiment. However, silicon carbide substrate 1 of the fifth embodiment is different from that of the first embodiment in that an ohmic contact layer 50 is formed between base layer 10 and SiC layer 20 as an intermediate layer.

Namely, in silicon carbide substrate 1 of the fifth embodiment, ohmic contact layer 50 obtained by siliciding at least a portion of a metal layer is disposed as an intermediate layer between base layer 10 and SiC layer 20. Base layer 10 and SiC layer 20 are connected to each other by this ohmic contact layer 50. Ohmic contact layer 50 thus existing facilitates to provide silicon carbide substrate 1 in which base layer 10 and SiC layer 20 having different impurity concentrations are stacked on each other.

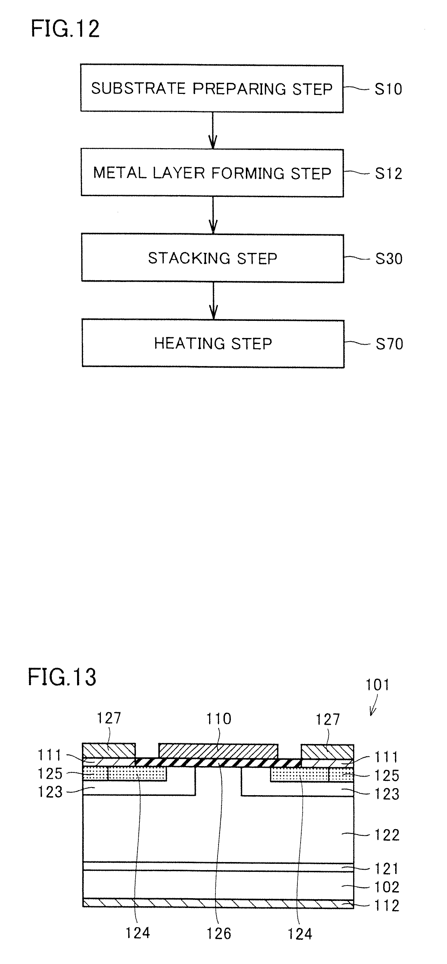

The following describes a method for manufacturing silicon carbide substrate 1 in the fifth embodiment. Referring to Fig. 12, in the method for manufacturing silicon carbide substrate 1 in the fifth embodiment, the substrate preparing step is performed as step (S10) in the same way as in the first embodiment, so as to prepare base substrate 10 and SiC substrate 20.

Next, a metal layer forming step is performed as a step (S12). In this step (S12), the metal layer is formed by, for example, depositing the metal on one main surface of base substrate 10 prepared in step (S10). This metal layer contains a metal forming silicide by heating, for example, contains at least one of nickel, molybdenum, titanium, aluminum, and tungsten.

Next, a stacking step is performed as step (S30). In this step (S30), SiC substrate 20 prepared in step (S10) is placed on the metal layer formed in step (S12). In this way, a stacked substrate is obtained in which SiC substrate 20 is provided over base substrate 10 with the metal layer interposed therebetween.

Next, as a step (S70), a heating step is performed. In this step (S70), the stacked substrate fabricated in step (S30) is heated to approximately 1000°C in an inert gas atmosphere such as argon, for example. In this way, at least portions of the metal layer (its region in contact with base substrate 10 and its region in contact with SiC substrate) is silicided to form ohmic contact layer 50. Accordingly, silicon carbide substrate 1 of the fifth embodiment can be readily manufactured in which base layer 10 and SiC layer 20 having different impurity concentrations are connected to each other by ohmic contact layer 50.

It should be noted that each of the fourth and fifth embodiments has illustrated that each of amorphous SiC layer 40 and ohmic contact layer 50 is employed as the intermediate layer, but the intermediate layer is not limited to these. Instead of these, a carbon adhesive agent can be employed, for example.

It should be noted that in silicon carbide substrate 1, the crystal structure of silicon carbide constituting SiC layer 20 is preferably a hexagonal system, more preferably, 4H-SiC. Further, base layer 10 and SiC layer 20 (as well as adjacent SiC layers 20 in the case where a plurality of SiC layers 20 are provided) are preferably made of silicon carbide single-crystal having the same crystal structure. In this way, by employing silicon carbide single-crystal of the same crystal structure for base layer 10 and SiC layer 20, physical properties such as a thermal expansion coefficient become the same therebetween, thereby preventing warpage of silicon carbide substrate 1, separation of base layer 10 and SiC layer 20, or separation of SiC layers 20 in the processes of manufacturing silicon carbide substrate 1 and manufacturing a semiconductor device using silicon carbide substrate 1.

Further, the silicon carbide single-crystals respectively constituting SiC layer 20 and base layer 10 (as well as adjacent SiC layers 20 in the case where a plurality of SiC layers 20 are provided) preferably have c axes forming an angle of less than 1°, more preferably, less than 0.1°. Further, it is preferable that the c planes of the respective silicon carbide single-crystals thereof are not rotated from each other in the plane.

Further, base layer (base substrate) 10 preferably has a diameter of 2 inches or greater, more preferably, 6 inches or greater. Furthermore, silicon carbide substrate 1 preferably has a thickness of not less than 200 µm and not more than 1000 µm, more preferably, not less than 300 µm and not more than 700 µm. Further, SiC layer 20 preferably has a resistivity of 50 mΩcm or smaller, more preferably, 20 mΩcm or smaller.

### (Sixth Embodiment)

As a sixth embodiment, the following describes one exemplary semiconductor device fabricated using the above-described silicon carbide substrate of the present invention. Referring to Fig. 13, a semiconductor device 101 according to the present invention is a DiMOSFET (Double Implanted MOSFET) of vertical type, and has a substrate 102, a buffer layer 121, a breakdown voltage holding layer 122, p regions 123, n⁺ regions 124, p⁺ regions 125, an oxide film 126, source electrodes 111, upper source electrodes 127, a gate electrode 110, and a drain electrode 112 formed on the backside surface of substrate 102. Specifically, buffer layer 121 made of silicon carbide is formed on the front-side surface of substrate 102 made of silicon carbide of n type conductivity. As substrate 102, there is employed a silicon carbide substrate of the present invention, inclusive of silicon carbide substrate 1 described in the first to fifth embodiments. In the case where silicon carbide substrate 1 in each of the first to fifth embodiments is employed, buffer layer 121 is formed on SiC layer 20 of silicon carbide substrate 1. Buffer layer 121 has n type conductivity, and has a thickness of, for example, 0.5 µm. Further, impurity with n type conductivity in buffer layer 121 has a concentration of, for example, 5 × 10¹⁷ cm⁻³. Formed on buffer layer 121 is breakdown voltage holding layer 122. Breakdown voltage holding layer 122 is made of silicon carbide of n type conductivity, and has a thickness of 10 µm, for example. Further, breakdown voltage holding layer 122 includes an impurity of n type conductivity at a concentration of, for example, 5 × 10¹⁵ cm⁻³.

Breakdown voltage holding layer 122 has a surface in which p regions 123 of p type conductivity are formed with a space therebetween. In each of p regions 123, an n⁺ region 124 is formed at the surface layer of p region 123. Further, at a location adjacent to n⁺ region 124, a p⁺ region 125 is formed. Oxide film 126 is formed to extend on n⁺ region 124 in one p region 123, p region 123, an exposed portion of breakdown voltage holding layer 122 between the two p regions 123, the other p region 123, and n⁺ region 124 in the other p region 123. On oxide film 126, gate electrode 110 is formed. Further, source electrodes 111 are formed on n⁺ regions 124 and p⁺ regions 125. On source electrodes 111, upper source electrodes 127 are formed. Moreover, drain electrode 112 is formed on the backside surface of substrate 102, i.e., the surface opposite to its front-side surface on which buffer layer 121 is formed.

Semiconductor device 101 in the present embodiment employs, as substrate 102, the silicon carbide substrate of the present invention, such as silicon carbide substrate 1 described in each of the first to fifth embodiments. Namely, semiconductor device 101 includes: substrate 102 serving as the silicon carbide substrate; buffer layer 121 and breakdown voltage holding layer 122 both serving as epitaxial growth layers formed on and above substrate 102; and source electrodes 111 formed on breakdown voltage holding layer 122. Substrate 102 is a silicon carbide substrate of the present invention such as silicon carbide substrate 1. Here, as described above, in the silicon carbide substrate of the present invention, resistivity is reduced in the thickness direction thereof while restraining stacking faults from being produced due to heat treatment. Hence, semiconductor device 101 has reduced on-resistance and excellent crystallinity in buffer layer 121 and breakdown voltage holding layer 122, each of which is formed as an epitaxial layer on/over substrate 102.

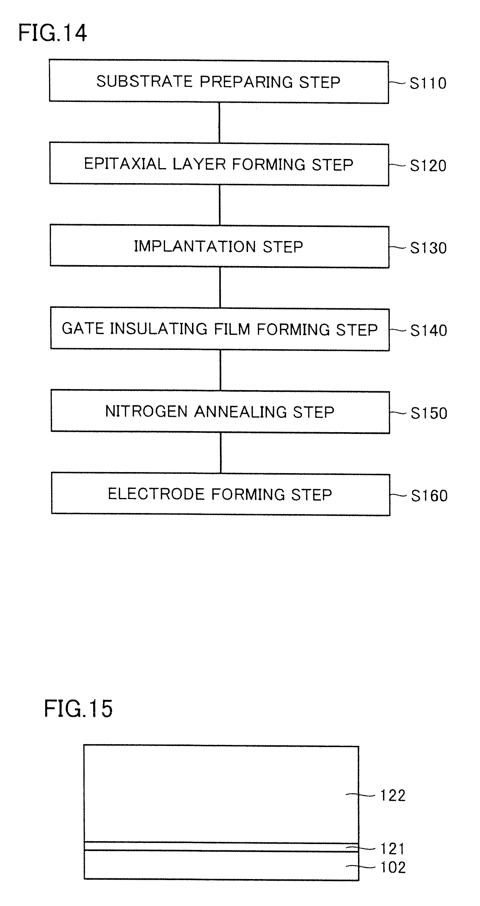

The following describes a method for manufacturing semiconductor device 101 shown in Fig. 13, with reference to Fig. 14-Fig. 18. Referring to Fig. 14, first, a substrate preparing step (S110) is performed. Prepared here is, for example, substrate 102, which is made of silicon carbide and has its main surface corresponding to the (03-38) plane (see Fig. 15). As substrate 102, there is prepared a silicon carbide substrate of the present invention, inclusive of silicon carbide substrate 1 manufactured in accordance with each of the manufacturing methods described in the first to fifth embodiments.

As substrate 102 (see Fig. 15), a substrate may be employed which has n type conductivity and has a substrate resistance of 0.02 Ωcm.

Next, as shown in Fig. 14, an epitaxial layer forming step (S120) is performed. Specifically, buffer layer 121 is formed on the front-side surface of substrate 102. Buffer layer 121 is formed on SiC layer 20 of silicon carbide substrate 1 employed as substrate 102 (see Fig. 1, Fig. 8, Fig. 9, and Fig. 11). As buffer layer 121, an epitaxial layer is formed which is made of silicon carbide of n type conductivity and has a thickness of 0.5 µm, for example. Buffer layer 121 has a conductive impurity at a concentration of, for example, 5 × 10¹⁷ cm⁻³. Then, on buffer layer 121, breakdown voltage holding layer 122 is formed as shown in Fig. 15. As breakdown voltage holding layer 122, a layer made of silicon carbide of n type conductivity is formed using an epitaxial growth method. Breakdown voltage holding layer 122 can have a thickness of, for example, 10 µm. Further, breakdown voltage holding layer 122 includes an impurity of n type conductivity at a concentration of, for example, 5 × 10¹⁵ cm⁻³.

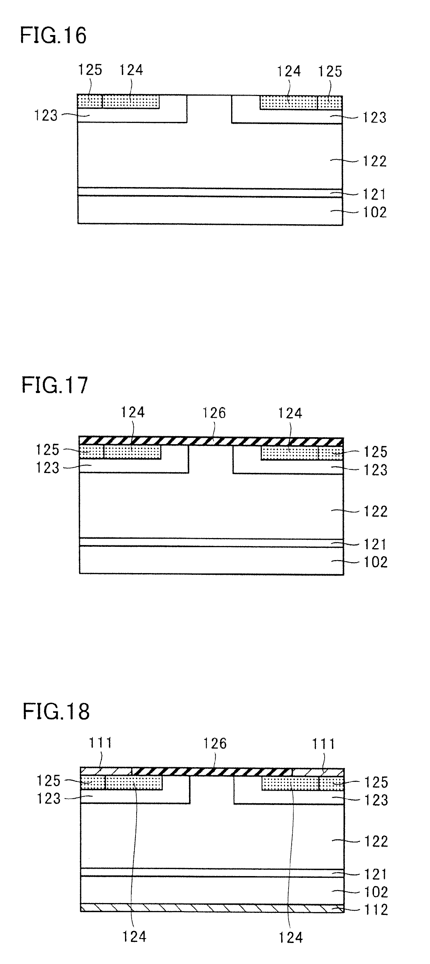

Next, as shown in Fig. 14, an implantation step (S130) is performed. Specifically, an impurity of p type conductivity is implanted into breakdown voltage holding layer 122 using, as a mask, an oxide film formed through photolithography and etching, thereby forming p regions 123 as shown in Fig. 16. Further, after removing the oxide film thus used, an oxide film having a new pattern is formed through photolithography and etching. Using this oxide film as a mask, a conductive impurity of n type conductivity is implanted into predetermined regions to form n⁺ regions 124. In a similar way, a conductive impurity of p type conductivity is implanted to form p⁺ regions 125. As a result, the structure shown in Fig. 16 is obtained.

After such an implantation step, an activation annealing process is performed. This activation annealing process can be performed under conditions that, for example, argon gas is employed as atmospheric gas, heating temperature is set at 1700°C, and heating time is set at 30 minutes.

Next, a gate insulating film forming step (S140) is performed as shown in Fig. 14. Specifically, as shown in Fig. 17, oxide film 126 is formed to cover breakdown voltage holding layer 122, p regions 123, n⁺ regions 124, and p⁺ regions 125. As a condition for forming oxide film 126, for example, dry oxidation (thermal oxidation) may be performed. The dry oxidation can be performed under conditions that the heating temperature is set at 1200°C and the heating time is set at 30 minutes.

Thereafter, a nitrogen annealing step (S150) is performed as shown in Fig. 14. Specifically, an annealing process is performed in atmospheric gas of nitrogen monoxide (NO). Temperature conditions for this annealing process are, for example, as follows: the heating temperature is 1100°C and the heating time is 120 minutes. As a result, nitrogen atoms are introduced into a vicinity of the interface between oxide film 126 and each of breakdown voltage holding layer 122, p regions 123, n⁺ regions 124, and p⁺ regions 125, which are disposed below oxide film 126. Further, after the annealing step using the atmospheric gas of nitrogen monoxide, additional annealing may be performed using argon (Ar) gas, which is an inert gas. Specifically, using the atmospheric gas of argon gas, the additional annealing may be performed under conditions that the heating temperature is set at 1100°C and the heating time is set at 60 minutes.

Next, as shown in Fig. 14, an electrode forming step (S160) is performed. Specifically, a resist film having a pattern is formed on oxide film 126 by means of the photolithography method. Using the resist film as a mask, portions of the oxide film above n⁺ regions 124 and p⁺ regions 125 are removed by etching. Thereafter, a conductive film such as a metal is formed on the resist film and formed in openings of oxide film 126 in contact with n⁺ regions 124 and p⁺ regions 125. Thereafter, the resist film is removed, thus removing the conductive film's portions located on the resist film (lift-off). Here, as the conductor, nickel (Ni) can be used, for example. As a result, as shown in Fig. 18, source electrodes 111 and drain electrode 112 can be obtained. It should be noted that on this occasion, heat treatment for alloying is preferably performed. Specifically, using atmospheric gas of argon (Ar) gas, which is an inert gas, the heat treatment (alloying treatment) is performed with the heating temperature being set at 950°C and the heating time being set at 2 minutes.

Thereafter, on source electrodes 111, upper source electrodes 127 (see Fig. 13) are formed. Further, gate electrode 110 (see Fig. 13) is formed on oxide film 126. In this way, semiconductor device 101 shown in Fig. 13 can be obtained. Namely, semiconductor device 101 is fabricated by forming the epitaxial layers and the electrodes on/over SiC layer 20 of silicon carbide substrate 1.

It should be noted that in the sixth embodiment, the vertical type MOSFET has been illustrated as one exemplary semiconductor device that can be fabricated using the silicon carbide substrate of the present invention, but the semiconductor device that can be fabricated is not limited to this. For example, various types of semiconductor devices can be fabricated using the silicon carbide substrate of the present invention, such as a JFET (Junction Field Effect Transistor), an IGBT (Insulated Gate Bipolar Transistor), and a Schottky barrier diode. Further, the sixth embodiment has illustrated a case where the semiconductor device is fabricated by forming the epitaxial layer, which serves as an active layer, on the silicon carbide substrate having its main surface corresponding to the (03-38) plane. However, the crystal plane that can be adopted for the main surface is not limited to this and any crystal plane suitable for the purpose of use and including the (0001) plane can be adopted for the main surface.

### [Examples]

### (Example 1)

The following describes an example 1 of the present invention. An experiment was conducted to inspect on-resistance and presence/absence of stacking faults in the silicon carbide substrate of the present invention. The experiment was conducted in the following manner.

First, a base substrate and a SiC substrate were prepared, each of which was made of 4H-SiC and had a main surface corresponding to the (0001) plane. The base substrate was set to have an impurity concentration of 1 × 10²⁰ cm⁻³, and the SiC substrate was set to have an impurity concentration of 1 × 10¹⁹ cm⁻³. Further, each of the base substrate and the SiC substrate was set to contain nitrogen as its impurity, and was set to have a thickness of 200 µm. Then, the base substrate and the SiC substrate were connected to each other using the same method as that in the first embodiment, thereby obtaining a silicon carbide substrate in which the SiC layer was formed on the base layer (example A). On the other hand, for the purpose of comparison, a substrate was prepared which was configured similarly to the above-described SiC substrate and had a thickness of 400 µm (comparative example A). In addition, a substrate was also prepared which was configured similarly to the base substrate and had a thickness of 400 µm (comparative example B). Then, on-resistance was measured for each of the example and comparative examples.

The measurement of on-resistance was conducted in the following manner. First, the main surface of the SiC layer of example A and the main surfaces of comparative examples A, B which correspond to the (0001) plane were polished. Then, an ohmic electrode was formed on the main surface of example A at the base substrate side (backside surface side) and an ohmic electrode was formed on the main surface of each of comparative examples A, B which corresponds to the (000-1) plane. Thereafter, a Schottky electrode was formed on the polished main surface of the SiC layer of example A, and a Schottky electrode was formed on the main surface corresponding to the (0001) plane in each of comparative examples A, B. In this way, the Schottky diodes were fabricated for evaluation of the on-resistance. Thereafter, they were formed into chips by means of dicing, were mounted in packages, and measured in forward characteristics of the Schottky diodes. Then, the on-resistance was measured based on the slope in each of saturation regions thereof. Further, each of the substrates was maintained at 1150°C for 90 minutes for dry oxidation. Then, whether stacking faults were present or absent therein was inspected. It should be noted that whether stacking faults were present or absent was not checked in the base layer of example A. A result of the experiment is shown in Table 1.

**[Table 1]**

| | | Impurity Concentration (cm⁻³) | Thickness (µm) | On-Resistance (mΩcm²) | Presence/Absence of Stacking Faults |
|---|---|---|---|---|---|
| Example A | SiC Layer | 1 × 10¹⁹ | 200 | 0.22 | Absent |
| | Base Layer | 1 × 10²⁰ | 200 | | - |
| Comparative Example A | | 1 × 10¹⁹ | 400 | 0.32 | Absent |
| Comparative Example B | | 1 × 10²⁰ | 400 | 0.12 | Present |

Referring to Table 1, comparative example A with an impurity concentration of 1 × 10¹⁹ cm⁻³ had an on-resistance of 0.32 mΩcm², whereas comparative example B with an impurity concentration of 1 × 10²⁰ cm⁻³ had an on-resistance reduced to 0.12 mΩcm². However, it was confirmed that stacking faults were produced in comparative example B upon the dry oxidation, which represented that in a process of fabricating a semiconductor device using the substrate thereof. Hence, it is considered difficult to fabricate a high-performance semiconductor device using the silicon carbide substrate of comparative example B.

In contrast, the on-resistance was 0.22 mΩcm² in the silicon carbide substrate of example A in which the base layer had an impurity concentration of 1 × 10²⁰ cm⁻³, which is greater than 2 × 10¹⁹ cm⁻³, and in which the SiC layer had an impurity concentration of 1 × 10¹⁹ cm⁻³, which is smaller than 2 × 10¹⁹ cm⁻³. Thus, the on-resistance of the silicon carbide substrate of example A was lower than that of comparative example A. Moreover, it was confirmed that stacking faults were not produced in the SiC layer in example A.

From the result of the experiment above, according to the silicon carbide substrate of the present invention, there can be provided a silicon carbide substrate allowing for reduced resistance while restraining stacking faults from being produced due to heat treatment.

It should be noted that the foregoing embodiments and example assume that one SiC layer is provided on the base, but the silicon carbide substrate of the present invention is not limited to this and a plurality of SiC layers may be stacked in the thickness direction. In this case, the SiC layers can be set to have impurity concentrations getting smaller as they are further away from the base layer. In this way, abrupt change of lattice constant caused due to a difference in impurity concentration in the thickness direction can be avoided, thereby restraining warpage, etc., of the silicon carbide substrate.

### (Example 2)

An experiment was conducted to confirm superiority of a semiconductor device fabricated using the silicon carbide substrate of the present invention. First, the same substrate as the silicon carbide substrate of example A of example 1 was prepared and used to fabricate a MOSFET similar to that of the sixth embodiment (example). Meanwhile, for comparison, the same substrate as the silicon carbide substrate of comparative example B of example 1 was prepared and used to fabricate a MOSFET similar to that of the sixth embodiment (comparative example).

As a result, in the case of the MOSFET of the comparative example, stacking faults were introduced into breakdown voltage holding layer 122 due to heating performed during epitaxial growth for providing breakdown voltage holding layer 122, thereby significantly decreasing yield of devices. In contrast, in the case of the MOSFET of the example, the yield was not decreased due to the introduction of stacking faults.

From the result of the experiment, it was confirmed that reduced on-resistance can be achieved while restraining decrease of yield by fabricating a vertical type device such as a vertical type MOSFET using the silicon carbide substrate of the present invention.

The silicon carbide substrate of the present invention can be used to fabricate a semiconductor device as described above in the sixth embodiment. Specifically, in the semiconductor device of the present invention, the epitaxial layer is formed on the silicon carbide substrate of the present invention as an active layer. More specifically, the semiconductor device of the present invention includes: the silicon carbide substrate of the present invention; the epitaxial growth layer formed on the silicon carbide substrate; and the electrodes formed on the epitaxial layer. Namely, the semiconductor device of the present invention includes: the base layer made of silicon carbide; the SiC layer made of single-crystal silicon carbide and disposed on the base layer; the epitaxial growth layer formed on the SiC layer; and the electrodes formed on the epitaxial layer. Further, the base layer has an impurity concentration greater than 2 × 10¹⁹ cm⁻³, and the SiC layer has an impurity concentration greater than 5 × 10¹⁸ cm⁻³ and smaller than 2 × 10¹⁹ cm⁻³.

The embodiments and examples disclosed herein are illustrative and non-restrictive in any respect. The scope of the present invention is defined by the terms of the claims, rather than the embodiments described above, and is intended to include any modifications within the scope and meaning equivalent to the terms of the claims.

### INDUSTRIAL APPLICABILITY

The silicon carbide substrate and the semiconductor device in the present invention are particularly advantageously applicable to a silicon carbide substrate required to achieve reduced resistivity in the thickness direction thereof while restraining stacking faults from being produced due to heat treatment, as well as a semiconductor device.

### REFERENCE SIGNS LIST

1, 2: silicon carbide substrate; 10: base layer (base substrate); 10A: main surface; 10B: single-crystal layer; 11: material substrate; 20: SiC layer (SiC substrate); 20A: main surface; 20B: end surface; 30: epitaxial growth layer; 40: amorphous SiC layer; 50: ohmic contact layer; 81: first heater; 82: second heater; 101: semiconductor device; 102: substrate; 110: gate electrode; 111: source electrode; 112: drain electrode; 121: buffer layer; 122: breakdown voltage holding layer; 123: p region; 124: n⁺ region; 125: p⁺ region; 126: oxide film; 127: upper source electrode.

## Claims

1. A silicon carbide substrate (1) comprising:
a base layer (10) made of silicon carbide; and
a SiC layer (20) made of single-crystal silicon carbide and disposed on said base layer (10),
said base layer (10) having an impurity concentration greater than 2 × 10¹⁹ cm⁻³,
said SiC layer (20) having an impurity concentration greater than 5 × 10¹⁸ cm⁻³ and smaller than 2 × 10¹⁹ cm⁻³.

2. The silicon carbide substrate (1) according to claim 1, further comprising an epitaxial growth layer (30) formed on said SiC layer (20) and made of single-crystal silicon carbide, wherein
said epitaxial growth layer (30) has a stacking fault density smaller than that in said base layer (10).

3. The silicon carbide substrate (1) according to claim 1, wherein the impurity contained in said base layer (10) is different from that contained in said SiC layer (20).

4. The silicon carbide substrate (1) according to claim 1, wherein:
the impurity contained in said base layer (10) is nitrogen or phosphorus, and
the impurity contained in said SiC layer (20) is nitrogen or phosphorus.

5. The silicon carbide substrate (1) according to claim 1, wherein a plurality of said SiC layers (20) are arranged side by side when viewed in a planar view.

6. The silicon carbide substrate (1) according to claim 1, wherein:
said base layer (10) is made of single-crystal silicon carbide, and
a half width of X-ray rocking curve of said SiC layer (20) is smaller than that of said base layer (10).

7. The silicon carbide substrate (1) according to claim 1, wherein:
said base layer (10) is made of single-crystal silicon carbide, and
said SiC layer (20) has a micro pipe density lower than that of said base layer (10).

8. The silicon carbide substrate (1) according to claim 1, wherein:
said base layer (10) is made of single-crystal silicon carbide, and
said SiC layer (20) has a dislocation density lower than that of said base layer (10).

9. The silicon carbide substrate (1) according to claim 1, wherein said base layer (10) includes a single-crystal layer (10B) made of single-crystal silicon carbide and including its main surface (10A) facing said SiC layer (20).

10. The silicon carbide substrate (1) according to claim 9, wherein a half width of X-ray rocking curve of said SiC layer (20) is smaller than that of said single-crystal layer (10B).

11. The silicon carbide substrate (1) according to claim 9, wherein said SiC layer (20) has a micro pipe density lower than that of said single-crystal layer (10B).

12. The silicon carbide substrate (1) according to claim 9, wherein said SiC layer (20) has a dislocation density lower than that of said single-crystal layer (10B).

13. The silicon carbide substrate (1) according to claim 1, wherein said SiC layer (20) has a main surface (20A) opposite to said base layer (10) and having an off angle of not less than 50° and not more than 65° relative to a {0001} plane.

14. The silicon carbide substrate (1) according to claim 13, wherein the main surface (20A) opposite to said base layer (10) has an off orientation forming an angle of 5° or smaller relative to a <1-100> direction.

15. The silicon carbide substrate (1) according to claim 14, wherein the main surface (20A) opposite to said base layer (10) has an off angle of not less than -3° and not more than 5° relative to a {03-38} plane in the <1-100> direction.

16. The silicon carbide substrate (1) according to claim 13, wherein the main surface (20A) opposite to said base layer (10) has an off orientation forming an angle of 5° or smaller relative to a <11-20> direction.

17. A semiconductor device (101) comprising:
a silicon carbide substrate (102);
an epitaxial growth layer (122) formed on said silicon carbide substrate (102); and
an electrode (111) formed on/over said epitaxial growth layer (122),
said silicon carbide substrate (102) being the silicon carbide substrate (1) recited in claim 1.
